# EUROPEAN PATENT SPECIFICATION

(11) **EP 4 447 319 B1**
(45) Date of publication and mention of the grant of the patent: **25.03.2026**
(21) Application number: 24170058.2
(22) Date of filing: 12.04.2024
(51) Int. Cl.: H03K 17/082, H03K 17/687, H01H 9/52, H05K 7/20, H01L 23/36

(54) **SOLID STATE RELAY MODULE**
FESTKÖRPERRELAISMODUL
MODULE DE RELAIS À SEMI-CONDUCTEURS

(30) Priority: 14.04.2023 US 202363459414 P; 14.04.2023 US 202363459446 P; 11.04.2024 US 202418632660
(43) Date of publication of application: 16.10.2024
(73) Proprietor: Aptiv Technologies AG, 8200 Schaffhausen (CH)
(72) Inventor: MLECZKO, Jamie, Oxford, MI 48371 (US); NG, Cheuk, Bloomfield Hills, MI 48301 (US); LI, Yu, Shanghai (CN)
(74) Representative: Bardehle Pagenberg Partnerschaft mbB Patentanwälte Rechtsanwälte

(56) References cited:
- WO-A1-2022/175107
- US-A1- 2019 296 731
- US-A1- 2022 263 502
- US-B2- 9 763 360

## Description

This disclosure is directed to an electrical relay module, and more particularly to a solid state relay module with overcurrent protection.

Mechanical contactors are heavy-duty relays that are used as switches to open and close electrical circuits in high-voltage, e.g., greater than 50 volt, applications. However, mechanical contactors are slow and have a limited lifespan ending in mechanical or electrical failure of the contactors. These failures may increase costs of warranty claims for manufacturers using these mechanical devices.

US 2022/0263502 A1 relates generally to the field of electrical relays and breakers, and in particular to a solid state contactor assembly, for making and breaking direct current.

US 9,763,360 B2 discloses an electrical assembly that may include an enclosure having a base portion to attach the enclosure to a panel and a heat dissipating portion opposite the base portion , a circuit board having a first thermal interface on a first side of the board, a second thermal interface on a second side of the board, and a thermally conductive portion to provide enhanced thermal conduction between the first thermal interface and the second thermal interface , a power electronic device having a thermal interface coupled to the first thermal interface of the circuit board, a heat spreader arranged to transfer heat to the heat dissipating portion of the enclosure, and a thermally conductive pad coupled between the second thermal interface of the circuit board and the heat spreader.

US 2019/0296731 A1 provides a technique to complement overcurrent protection and short circuit protection.

In some aspects, the techniques described herein relate to a solid state relay module that includes a first solid state switch, an electronic controller, a top cover, and a bottom cover. The first solid state switch is configured to establish and break an electrical connection between a first high-voltage input terminal and a first high-voltage output terminal disposed on a power circuit board. The electronic controller is in communication with the first solid state switch and configured to put the first solid state switch in a conductive state or in a nonconductive state. The top cover is formed of an electrically insulative thermoplastic material, wherein the power circuit board is disposed within a cavity defined by the top cover and wherein the top cover defines a plurality of openings through which the first high-voltage input terminal and the first high-voltage output terminal extend. The bottom cover is formed of a thermally conductive material and is in thermal communication with the first solid state switch. A compliant thermal interface paste is disposed between an inner surface of the bottom cover and surfaces of the first solid state switch and a resilient thermal interface pad is attached to an outer surface of the bottom cover by a first adhesive layer on an inner surface of the resilient thermal interface pad.

The present invention will now be described by way of example with reference to the accompanying drawings, in which:
**FIG. 1** illustrates an isometric view of a miniature solid state relay (SSR) module according to some embodiments.
**FIG. 2** illustrates an exploded view of the SSR module of **FIG. 1** according to some embodiments.
**FIG. 3** illustrates a top view of the SSR module of **FIG. 1** according to some embodiments.
**FIG. 4** illustrates a bottom view of the SSR module of **FIG. 1** according to some embodiments.
**FIG. 5** illustrates a side view of the SSR module of **FIG. 1** according to some embodiments.
**FIG. 6** illustrates a cross-section view of the SSR module of **FIG. 1** according to some embodiments.
**FIG. 7A** illustrates a top view of a power circuit board of the SSR module of **FIG. 1** according to some embodiments.
**FIG. 7B** illustrates a bottom view of the power circuit board of **FIG. 7A** according to some embodiments.
**FIG. 8A** illustrates a top view of a control circuit board of the SSR module of **FIG. 1** according to some embodiments.
**FIG. 8B** illustrates a bottom view of the control circuit board of **FIG. 8A** according to some embodiments.
**FIG. 9** illustrates a schematic electrical diagram of a miniature solid state relay (SSR) module according to some embodiments.
**FIG. 10** illustrates a schematic electrical diagram of protection circuitry of the SSR module of **FIG. 1** according to some embodiments.

Described herein is a miniature solid state relay module, hereafter referred to as the SSR module, which is well suited for high-voltage automotive applications. The SSR module may be integrated into another device (but need not to be) and therefore size, connections, cost, and thermal management are significant parameters when considering packaging for the SSR module. To optimize each of these parameters, the SSR module may be contained in an electrically insulated housing. This package contains the parts for environed protection of the electrical components, structural support, and thermal dissipation. The SSR module presented herein has a smaller size and lower manufacturing costs than previous relay modules.

The SSR module includes a power printed circuit board (PCB) with threaded post connections for the power terminals. The SSR module uses top side cooled metal-oxide-semiconductor field-effect transistors (MOSFETs) that allows these devices to be cooled by conduction to a cold plate located exterior to the SSR module. The MOSFETs are attached to the PCB. In some embodiments the overmolded package may fully encapsulate the MOSFETs for mechanical protection and electrical isolation. In other embodiments, the overmolded package may leave the thermal dissipation surface of the MOSFETs exposed for reduced thermal impedance between the SSR module and the cold plate. In other embodiments, standard MOSFETs without cooling features alternatively may be used. The SSR module may also include snubber resistors and snubber capacitors also mounted on the PCB.

In contrast to traditional mechanical relays or contactors which use spring loaded terminals, the SSR module has the advantage of having no moving mechanical parts. The electrical switching is carried out by solid state components, e.g., MOSFETs. These solid state components have much better reliability than the mechanical contactors. These solid state components also have much faster response time which may be enhanced by pre-charging techniques. These solid state components are easily resettable and are much smaller than equivalent mechanical contactors.

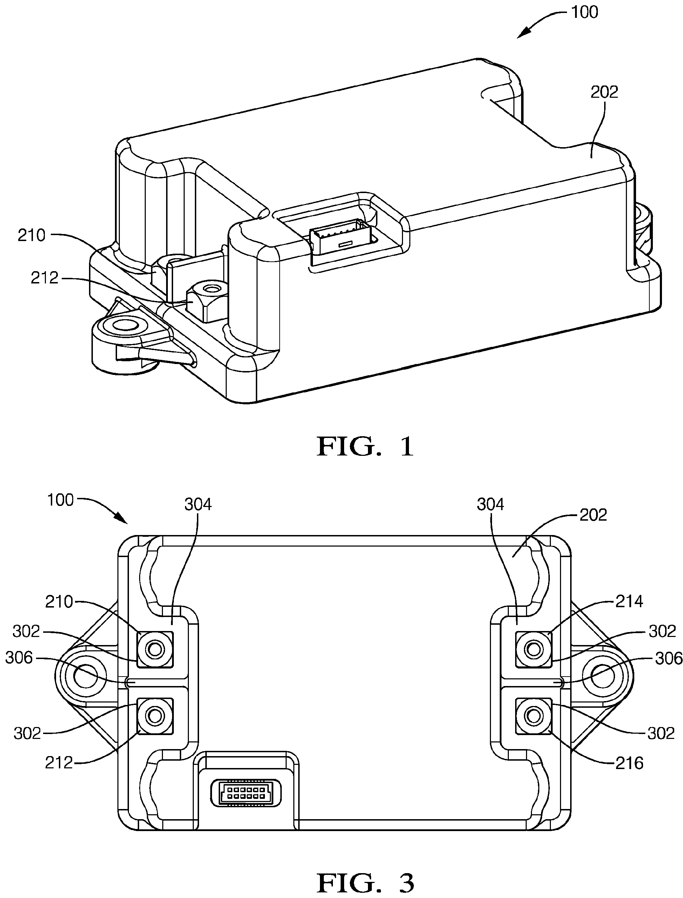

**FIG. 1** illustrates an isometric view of a non-limiting example of a miniature solid state relay module according to some embodiments, hereafter referred to as the SSR module 100.

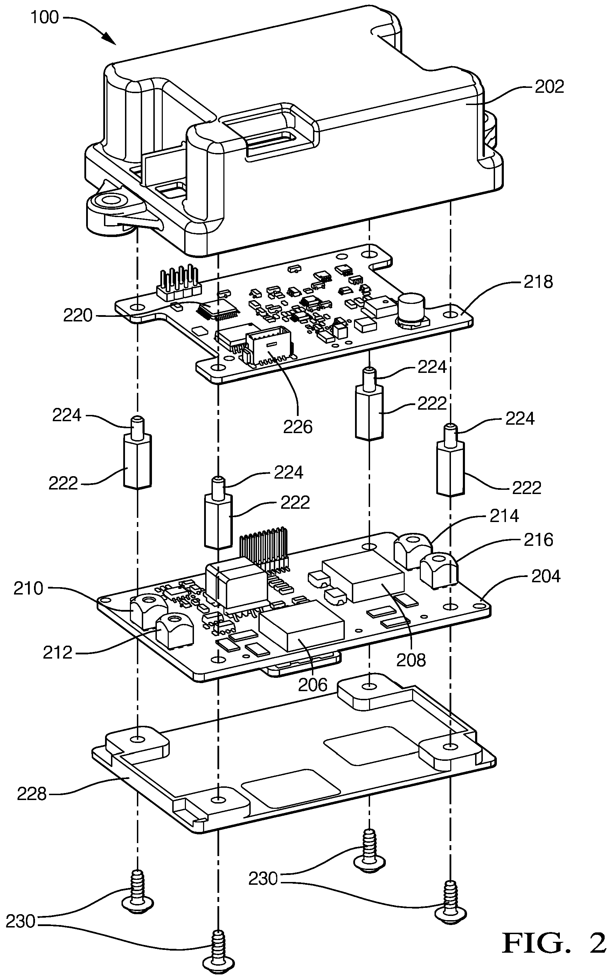

**FIG. 2** shows an exploded view of the SSR module 100 which includes a top cover 202 formed of an electrically insulative thermoplastic material, e.g. polyamine or polybutylene terephthalate. A power circuit board 204 having first and second solid state switches 206, 208, e.g., metal-oxide-semiconductor field-effect transistors (MOSFETs) is disposed within a cavity defined by the top cover 202. The power circuit board 204 also has first and second high-voltage input terminals 210, 212 that are configured to be connected to a high-voltage electrical power source, such as a battery pack and first and second high-voltage output terminals 214, 216 that are configured to be connected to an electrical load, such as a DC to AC invertor, a DC-DC convertor, or a primarily resistive load, e.g., a heater. The terminals 210-216 may be connected to the high-voltage electrical power source and the electrical load by busbars (not shown) connected to the terminals 210-216.

The SSR module also includes a control circuit board 218 disposed within the cavity in the top cover 202. The control circuit board 218 has an electronic controller 220 configured to switch the first and second solid state switches 206, 208 on and off to provide electrical power from the power source to the electrical load, pre-charge the electrical load, and/or protect the SSR module 100 from damage from overcurrent conditions.

The control circuit board 218 is electrically connected to the power circuit board 204 by an interface connector and is mechanically connected to the power circuit board 204 by a plurality of standoffs 222. In this example, the standoffs 222 define studs 224 that extend through holes in the corners of the control circuit board 218 to attach the control circuit board 218 to the top cover 202. The studs 224 may be threaded and screw into the top cover 202 or may be smooth and are press fit into holes in the top cover.

The control circuit board 218 also includes a connector 226 having a plurality of low-voltage terminals extending from the control circuit board 218. As used herein, high voltage describes voltages greater than or equal to 50 volts and low-voltage describes voltages less than 50 volts. The top cover 202 defines an aperture through which the plurality of low-voltage terminals may be accessed. The connector 226 is attached to the top cover 202 via the control circuit board 218 rather than being directly attached to the top cover 202.

The SSR module 100 also includes a bottom cover 228 that encloses the power circuit board 204 and the control circuit board 218 within the top cover 202. The bottom cover 228 is formed of a thermally conductive material, such as aluminum. Threaded fasteners 230 are inserted into holes in the corners of the bottom cover 228. The threaded fasteners 230 further extend through holes in the power circuit board 204 and are received into threaded holes in the standoffs 222, thereby securing the bottom cover 228 and the power circuit board 204 to the top cover 202.

**FIG. 3** illustrates a top view of the SSR module 100. The top cover 202 defines openings 302 through with the input terminals 210, 212 and the output terminal 214, 216 protrude. The top cover 202 also defines grooves 304 in each of two opposing sides of the top cover 202 around the openings 302 that are configured to accommodate the bus bars attached to the input terminals 210, 212 and the output terminal 214, 216. In alternative embodiments, these grooves 304 may accommodate terminals at the ends of wire cables. The top cover 202 also defines walls 306 dividing at least a portion of the grooves 304 which separate the input terminals 210, 212 from one another and the output terminal 214, 216 from one another. The walls 306 electrically insulate the input terminals 210, 212 from one another and the output terminal 214, 216 from one another.

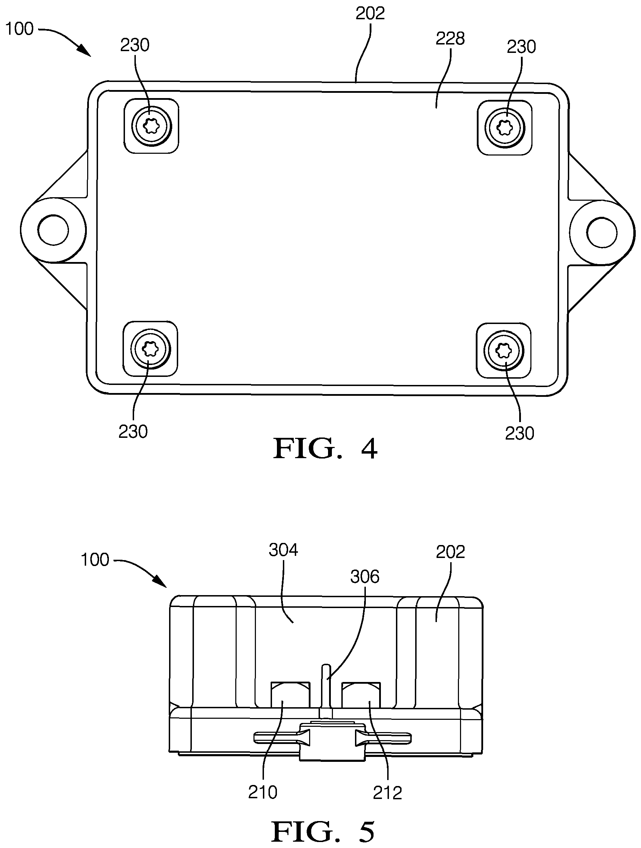

**FIG. 4** illustrates a bottom view of the SSR module 100 in which the top cover 202, the bottom cover 228, and the threaded fasteners 230 may be seen..

**FIG. 5** illustrates a side view of the SSR module 100 in which the top cover 202, the input terminals 210, 212, the bottom cover 228, the groove 304 and the wall 306 between the input terminals 210, 212 may be seen.

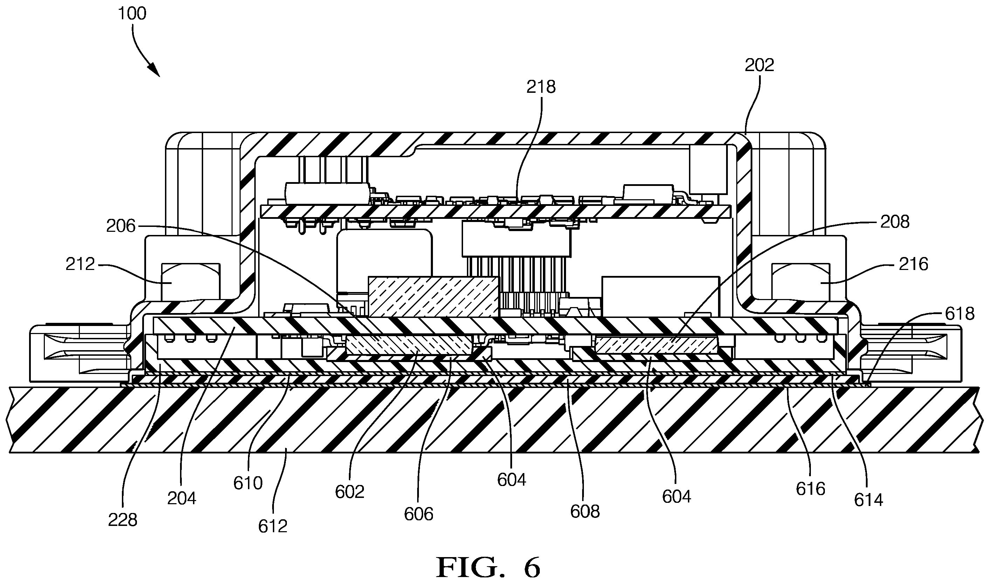

**FIG. 6** illustrates a cross-section view of the SSR module 100. The first and second solid state switches 206, 208 generate waste heat that needs to be drawn out from the SSR module 100. The first and second solid state switches 206, 208 illustrated herein are MOSFET devices that have an integral heat sink 602, commonly referred to as a top-side cooling MOSFET. These heat sinks are 602 arranged on the bottom side of the power circuit board 204 so that they may provide optimal heat transfer from the first and second solid state switches 206, 208 to the bottom cover 228. As shown in **FIG. 6****,** a compliant thermal interface paste 604 is disposed between an inner surface 606 of the bottom cover 228 and the heat sinks 602 of the first and second solid state switches 206, 208. The compliant thermal interface paste 604 may be a silicone or ceramic based thermal paste. The SSR module includes a resilient thermal interface pad 608 on an outer surface 610 of the bottom cover 228 to increase the thermal conductivity between the bottom cover 228 and a cooling channel 612 to which the SSR module 100 may be mounted. The cooling channel 612 is separate from the SSR module 100 and is a heat sink for the SSR module 100 that contains a liquid or gaseous coolant flowing therethrough. An inner surface of the thermal interface pad 608 is attached to the outer surface 610 of the bottom cover 228 by a first adhesive layer 614. An outer surface of the thermal interface pad 608 is covered by a second adhesive layer 616 that is used to attach the thermal interface pad 608 to the cooling channel 612. The SSR module 100 also includes a removable protective film 618 over the second adhesive layer 616 that protects the second adhesive layer 616 until the SSR module 100 is mounted on the cooling channel 612.

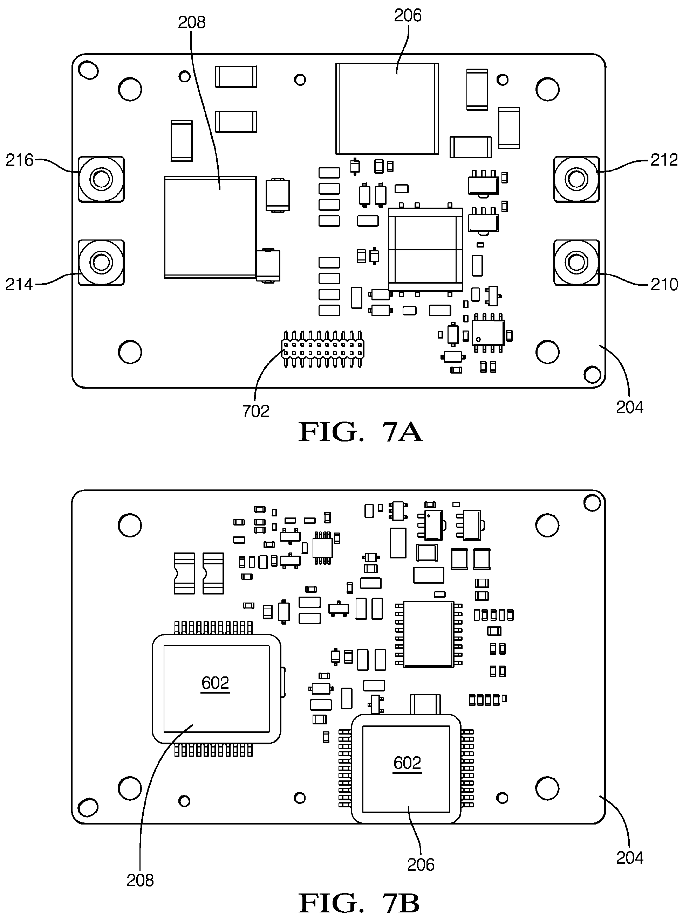

**FIG. 7A** illustrates a top view of a power circuit board 204. The top side of the power circuit board 204 contains the first and second high-voltage input terminals 210, 212, the first and second high-voltage output terminals 214, 216, and various other electronic components, such as resistors, capacitors, diodes and transistors. The top side of the power circuit board 204 also includes a male pin board to board connector 702 that is configured to connect the power circuit board 204 to the control circuit board 218.

**FIG. 7B** illustrates a bottom view of the power circuit board 204. The bottom side of the power circuit board contains the first and second solid state switches 206, 208. The integral heat sinks 602 are on the are on the bottom side of the power circuit board 204 so that they may be in thermal contact with the bottom cover 228. As can be seen in FIG. 7A, the first and second solid state switches 206, 208 extend from the bottom side of the power circuit board 204 through cut outs in the power circuit board 204. The bottom side of the power circuit board 204 also contains various other electronic components, such as resistors, capacitors, diodes and transistors.

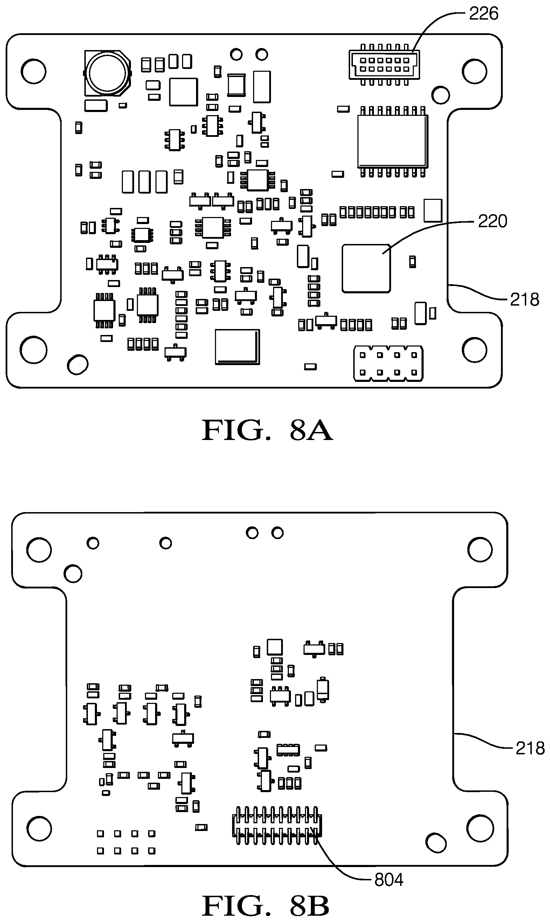

**FIG. 8A** illustrates a top view of a control circuit board 218. The top side of the control circuit board 218 includes the electronic controller 220 and the connector 226 as well as various other electronic components, such as resistors, capacitors, diodes and transistors.

**FIG. 8B** illustrates a bottom view of the control circuit board 218. The bottom side of the control circuit board 218 includes a female pin board to board connector 804 that is configured to mate with the male pin board to board connector 702 on the power circuit board 204 as well as various other electronic components, such as resistors, capacitors, diodes and transistors.

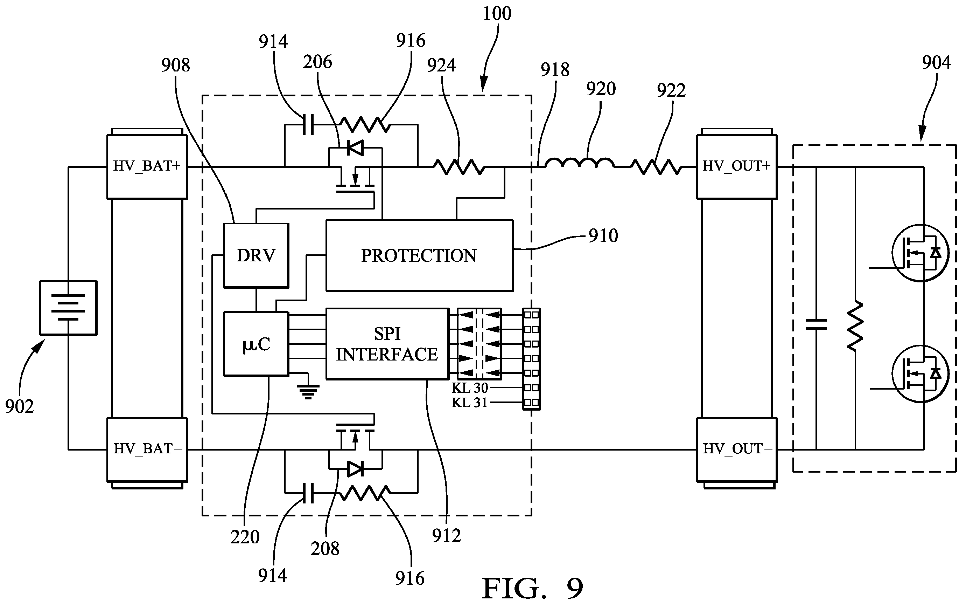

**FIG. 9** shows a schematic electrical diagram of a non-limiting example of a miniature solid state relay module, hereafter referred to as the SSR module 100. The SSR module 100 is connected to an electrical power source, such as the battery 902, and an electrical load 904 as shown in **FIG. 9****.** The SSR module 100 includes the solid state switch 206 and the solid state switch 208 controlled by an electronic controller 220, e.g., a microprocessor by means of a drive circuit 908. In alternative embodiments of the SSR module, the second solid state switch may be eliminated and replaced with an electrical conductor. The SSR module 100 also includes protection circuitry 910 connected to the drive circuit 908 to detect overcurrent conditions and communication circuitry 912 connected to the electronic controller 220 to provide digital communication between the SSR module and other electronic systems, e.g., electronic systems in an electric vehicle. The SSR module 100 further includes snubber circuits having a capacitive component 914 and a resistive component 916 connected in parallel with the solid state switch 206 and the solid state switch 208 to protect these switches. The SSR module 100 includes a connector 918 that connects the SSR module 100 to the electrical load 904. The connector 918 between the SSR module 100 and the electrical load 904 may have resistive and inductive properties modeled here by the inductive element 920 and the resistive element 922.

The SSR module 100 in this example is configured to have a normal operating voltage of around 420 volts and withstand voltage transients of around 600 volts. Alternative examples of the SSR module 100 may have different operating voltage ranges. Examples of the electrical load 904 may be a DC to AC invertor, a DC-DC convertor, or a primarily resistive load, e.g., a heater.

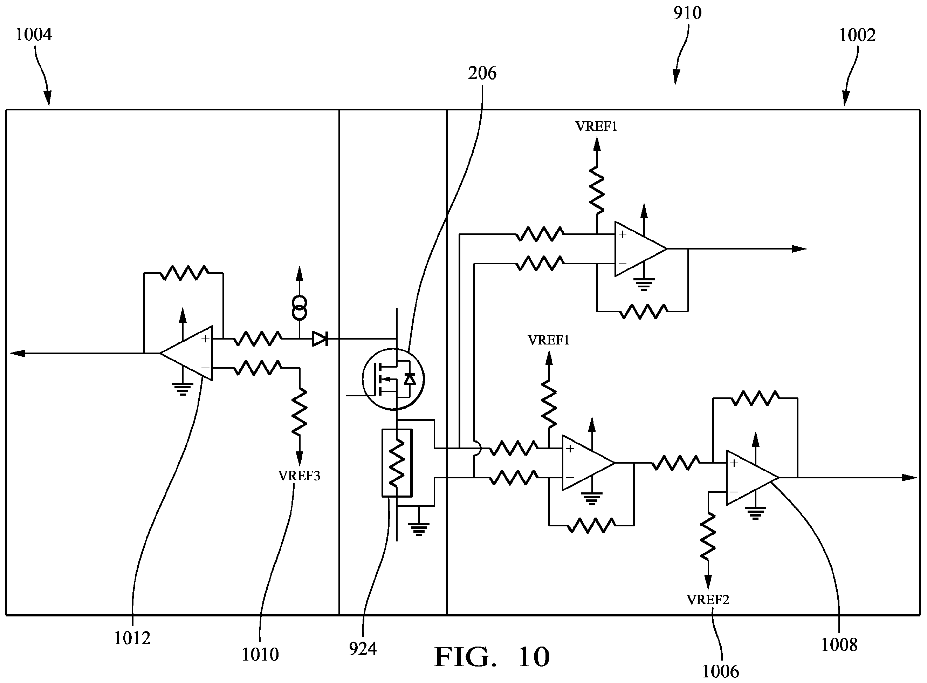

**FIG. 10** shows a detailed schematic electrical diagram of the protection circuitry 910 of the SSR module 100. The solid state switch 206 is connected to a shunt-based overcurrent detection circuit, hereafter referred to as the shunt OCD circuit 1002, and a desaturation-based overcurrent detection circuit, hereafter referred to as the DESAT OCD circuit 1004. Without subscribing to any particular theory of operation, the shunt OCD circuit 1002 detects an overcurrent condition by amplifying the voltage across a shunt resistor 924 shown in **FIG. 9** as being in series with the solid state switch 206 and comparing it to a preset reference voltage 1006 using the shunt comparator 1008. The voltage measured across the shunt resistor 924 is representative of the current provided at the output of the SSR module 100. Without subscribing to any particular theory of operation, the DESAT OCD circuit 1004 detects an overcurrent condition by comparing the source to drain voltage of the solid state switch 206 to another preset reference voltage 1010 using the DESAT comparator 1012. The source to drain voltage of the solid state switch 206 has a substantial increase when an overcurrent condition occurs. This source to drain voltage increase depends on the characteristic of the MOSFET and the gate drive condition.

### Discussion of Possible Embodiments

The following are non-exclusive descriptions of possible embodiments of the present invention.

In some aspects, the techniques described herein relate to a solid state relay module, including: a first solid state switch configured to establish and break an electrical connection between a first high-voltage input terminal and a first high-voltage output terminal disposed on a power circuit board; an electronic controller in communication with the first solid state switch and configured to put the first solid state switch in a conductive state or in a nonconductive state; a top cover formed of an electrically insulative thermoplastic material, wherein the power circuit board is disposed within a cavity defined by the top cover and wherein the top cover defines a plurality of openings through which the first high-voltage input terminal and the first high-voltage output terminal extend; a bottom cover formed of a thermally conductive material and in thermal communication with the first solid state switch; a compliant thermal interface paste disposed between an inner surface of the bottom cover and surfaces of the first solid state switch; and a resilient thermal interface pad attached to an outer surface of the bottom cover by a first adhesive layer on an inner surface of the resilient thermal interface pad.

The solid state relay module of the preceding paragraph can optionally include, additionally and/or alternatively any, one or more of the following features, configurations and/or additional components.

In some aspects, the techniques described herein relate to a solid state relay module, further including: a second solid state switch configured to establish and break an electrical connection between a second high-voltage input terminal and a second high-voltage output terminal disposed on the power circuit board.

In some aspects, the techniques described herein relate to a solid state relay module, wherein the first solid state switch and the second solid state switch are metal-oxide-semiconductor field-effect transistors.

In some aspects, the techniques described herein relate to a solid state relay module, wherein the bottom cover is formed of a material having a thermal conductivity of at least 50 watts/meter-°K.

In some aspects, the techniques described herein relate to a solid state relay module, wherein the resilient thermal interface pad includes a removable film layer attached to a second adhesive layer on an outer surface of the resilient thermal interface pad.

In some aspects, the techniques described herein relate to a solid state relay module, wherein a first opening in the plurality of openings is defined in a first side of the top cover and a second opening in the plurality of openings is defined in a second side of the top cover opposite the first side.

In some aspects, the techniques described herein relate to a solid state relay module, wherein the top cover defines a plurality of notches in the first and second sides of the top cover which are sized, shaped, and arranged to accommodate a plurality of busbars attached to the first high-voltage input terminal and the first high-voltage output terminal.

In some aspects, the techniques described herein relate to a solid state relay module, wherein the first high-voltage input terminal and the first high-voltage output terminal have a planar interface surface configured to contact one of the plurality of busbars.

In some aspects, the techniques described herein relate to a solid state relay module, wherein a threaded hole is defined in each of the planar interface surfaces which is configured to accept a threaded fastener extending through a hole in each of the plurality of busbars, thereby attaching the plurality of busbars to the first high-voltage input terminal and the first high-voltage output terminal.

In some aspects, the techniques described herein relate to a solid state relay module, wherein the electronic controller is disposed on a control circuit board separate from the power circuit board and in electrical communication with the power circuit board.

In some aspects, the techniques described herein relate to a solid state relay module, wherein the control circuit board includes a plurality of low-voltage terminals extending from the control circuit board and wherein the top cover defines an aperture through which the plurality of low-voltage terminals may be accessed.

In some aspects, the techniques described herein relate to a solid state relay module, wherein the plurality of low-voltage terminals are attached to the top cover via the control circuit board.

In some aspects, the techniques described herein relate to a solid state relay module, further including a drive circuit connected to the first solid state switch and the electronic controller, wherein the drive circuit is configured to put the first solid state switch in the conductive state or in the nonconductive state due to commands from the electronic controller.

In some aspects, the techniques described herein relate to a solid state relay module, further including: a shunt overcurrent detection circuit in communication with the electronic controller; and a desaturation overcurrent detection circuit in communication with the electronic controller, wherein the electronic controller is configured to command the drive circuit to put the first solid state switch in the nonconductive state when the shunt overcurrent detection circuit or the desaturation overcurrent detection circuit detects an overcurrent condition.

In some aspects, the techniques described herein relate to a solid state relay module, wherein the electronic controller is configured to command the drive circuit to put the first solid state switch in the conductive state less than 200 nanoseconds after the shunt overcurrent detection circuit detects the overcurrent condition.

In some aspects, the techniques described herein relate to a solid state relay module, wherein the electronic controller is configured to command the drive circuit to put the first solid state switch in the nonconductive state less than 150 nanoseconds after the shunt overcurrent detection circuit detects the overcurrent condition.

In some aspects, the techniques described herein relate to a solid state relay module, wherein the shunt overcurrent detection circuit detects the overcurrent condition when a load current exceeds a second current threshold.

In some aspects, the techniques described herein relate to a solid state relay module, wherein the electronic controller is configured to command the drive circuit to put the first solid state switch in the nonconductive state less than 500 nanoseconds after the desaturation overcurrent detection circuit detects the overcurrent condition.

In some aspects, the techniques described herein relate to a solid state relay module, wherein the electronic controller is configured to command the drive circuit to put the first solid state switch in the nonconductive state less than 390 nanoseconds after the desaturation overcurrent detection circuit detects the overcurrent condition.

In some aspects, the techniques described herein relate to a solid state relay module, wherein the desaturation overcurrent detection circuit detects the overcurrent condition when a voltage across the first solid state switch exceeds a voltage threshold.

As used herein, 'one or more' includes a function being performed by one element, a function being performed by more than one element, e.g., in a distributed fashion, several functions being performed by one element, several functions being performed by several elements, or any combination of the above.

It will also be understood that, although the terms first, second, etc. are, in some instances, used herein to describe various elements, these elements should not be limited by these terms. These terms are only used to distinguish one element from another. For example, a first contact could be termed a second contact, and, similarly, a second contact could be termed a first contact, without departing from the scope of the various described embodiments. The first contact and the second contact are both contacts, but they are not the same contact.

The terminology used in the description of the various described embodiments herein is for the purpose of describing particular embodiments only and is not intended to be limiting. As used in the description of the various described embodiments and the appended claims, the singular forms "a", "an", and "the" are intended to include the plural forms as well, unless the context clearly indicates otherwise. It will also be understood that the term "and/or" as used herein refers to and encompasses any and all possible combinations of one or more of the associated listed items. It will be further understood that the terms "includes," "including," "comprises," and/or "comprising," when used in this specification, specify the presence of stated features, integers, steps, operations, elements, and/or components, but do not preclude the presence or addition of one or more other features, integers, steps, operations, elements, components, and/or groups thereof.

As used herein, the term "if" is, optionally, construed to mean "when" or "upon" or "in response to determining" or "in response to detecting," depending on the context. Similarly, the phrase "if it is determined" or "if [a stated condition or event] is detected" is, optionally, construed to mean "upon determining" or "in response to determining" or "upon detecting [the stated condition or event]" or "in response to detecting [the stated condition or event]," depending on the context.

Additionally, while terms of ordinance or orientation may be used herein these elements should not be limited by these terms. All terms of ordinance or orientation, unless stated otherwise, are used for purposes distinguishing one element from another, and do not denote any particular order, order of operations, direction or orientation unless stated otherwise.

## Claims

1. A solid state relay module (100), comprising:
a first solid state switch (206) configured to establish and break an electrical connection between a first high-voltage input terminal and a first high-voltage output terminal (214, 216) disposed on a power circuit board (204);
an electronic controller (220) in communication with the first solid state switch (206) and configured to put the first solid state switch (206) in a conductive state or in a nonconductive state;
a top cover (202) formed of an electrically insulative thermoplastic material, wherein the power circuit board (204) is disposed within a cavity defined by the top cover (202) and wherein the top cover (202) defines a plurality of openings (302) through which the first high-voltage input terminal (210) and the first high-voltage output terminal (214) extend;
a bottom cover (228) formed of a thermally conductive material in thermal communication with the first solid state switch (206);
a thermal interface paste (604) disposed between an inner surface (606) of the bottom cover (228) and surfaces of the first solid state switch (206); and
a thermal interface pad (608) attached to an outer surface (610) of the bottom cover (228) by a first adhesive layer (614) on an inner surface (606) of the thermal interface pad (608),
wherein the thermal interface pad (608) comprises a removable film layer (618) attached to a second adhesive layer (616) on an outer surface (610) of the thermal interface pad (608).

2. The solid state relay module (100) in accordance with claim 1, further comprising:
a second solid state switch (210) configured to establish and break an electrical connection between a second high-voltage input terminal (212) and a second high-voltage output terminal (216) disposed on the power circuit board (204).

3. The solid state relay module (100) in accordance with claim 2, wherein the first solid state switch (206) and the second solid state switch (2308) are metal-oxide-semiconductor field-effect transistors.

4. The solid state relay module (100) in accordance with any one of the preceding claims, wherein the bottom cover (228) is formed of a material having a thermal conductivity of at least 50 watts/meter-°K.

5. The solid state relay module (100) in accordance with claim 1, wherein the top cover (202) defines a plurality of notches (304) in the top cover (202) which are sized, shaped, and arranged to accommodate a plurality of busbars attached to the first high-voltage input terminal (210) and the first high-voltage output terminal (214).

6. The solid state relay module (100) in accordance with claim 5, wherein the first high-voltage input terminal (210) and the first high-voltage output terminal (214) have a planar interface surface configured to contact one of the plurality of busbars.

7. The solid state relay module (100) in accordance with claim 6, wherein a threaded hole is defined in each of the planar interface surfaces which is configured to accept a threaded fastener extending through a hole in each of the plurality of busbars, thereby attaching the plurality of busbars to the first high-voltage input terminal (210) and the first high-voltage output terminal (214).

8. The solid state relay module (100) with any one of the preceding claims, wherein the electronic controller (220) is disposed on a control circuit board (218) separate from the power circuit board (204) and in electrical communication with the power circuit board (204).

9. The solid state relay module (100) with any one of the preceding claims, wherein the control circuit board (218) includes a plurality of low-voltage terminals (226) extending from the control circuit board (218) and wherein the top cover (202) defines an aperture through which the plurality of low-voltage terminals may be accessed.

10. The solid state relay module (100) in accordance with claim 9, wherein the plurality of low-voltage terminals are attached to the top cover (202) via the control circuit board (218).

11. The solid state relay module (100) with any one of the preceding claims, further comprising a drive circuit (908) connected to the first solid state switch (206) and the electronic controller (220), wherein the drive circuit (908) is configured to put the first solid state switch (206) in the conductive state or in the nonconductive state due to commands from the electronic controller (220).

12. The solid state relay module (100) in accordance with claim 11, further comprising:
a shunt overcurrent detection circuit in communication with the electronic con-troller (220); and
a desaturation overcurrent detection circuit in communication with the electron-ic controller (220), wherein the electronic controller (220) is configured to command the drive circuit (908) to put the first solid state switch (206) in the nonconductive state when the shunt overcurrent detection circuit or the desaturation overcurrent detection circuit detects an overcurrent condition.

13. The solid state relay module (100) in accordance with claim 12, wherein the electronic controller (220) is configured to command the drive circuit (908) to put the first solid state switch (206) in the conductive state less than 200 nanoseconds after the shunt overcurrent detection circuit or the desaturation overcurrent detection circuit detects an overcurrent condition.

## Patentansprüche

1. Festkörperrelaismodul (100), umfassend:
einen ersten Festkörperschalter (206), der konfiguriert ist, um eine elektrische Verbindung zwischen einem ersten Hochspannungseingangsanschluss und einem ersten Hochspannungsausgangsanschluss (214, 216), die auf einer Leistungsleiterplatte (204) angeordnet sind, herzustellen und zu unterbrechen;
eine elektronische Steuerung (220) in Kommunikation mit dem ersten Festkörperschalter (206) und konfiguriert, um den ersten Festkörperschalter (206) in einen leitenden Zustand oder in einen nichtleitenden Zustand zu versetzen;
eine obere Abdeckung (202), die aus einem elektrisch isolierenden thermoplastischen Material gebildet ist, wobei die Leistungsleiterplatte (204) innerhalb eines Hohlraums angeordnet ist, der durch die obere Abdeckung (202) definiert ist, und wobei die obere Abdeckung (202) eine Vielzahl von Öffnungen (302) definiert, durch die sich der erste Hochspannungseingangsanschluss (210) und der erste
Hochspannungsausgangsanschluss (214) erstrecken;
eine untere Abdeckung (228), die aus einem wärmeleitenden Material in thermischer Kommunikation mit dem ersten Festkörperschalter (206) gebildet ist;
eine Wärmeleitpaste (604), die zwischen einer inneren Oberfläche (606) der unteren Abdeckung (228) und Oberflächen des ersten Festkörperschalters (206) angeordnet ist; und
ein Wärmeleitpad (608), das an einer äußeren Oberfläche (610) der unteren Abdeckung (228) durch eine erste Klebeschicht (614) auf einer inneren Oberfläche (606) des Wärmeleitpads (608) befestigt ist,
wobei das Wärmeleitpad (608) eine entfernbare Filmschicht (618) umfasst, die an einer zweiten Klebeschicht (616) auf einer äußeren Oberfläche (610) des Wärmeleitpads (608) befestigt ist.

2. Festkörperrelaismodul (100) nach Anspruch 1, ferner umfassend:
einen zweiten Festkörperschalter (210), der konfiguriert ist, um eine elektrische Verbindung zwischen einem zweiten Hochspannungseingangsanschluss (212) und einem zweiten Hochspannungsausgangsanschluss (216), die auf der Leistungsleiterplatte (204) angeordnet sind, herzustellen und zu unterbrechen.

3. Festkörperrelaismodul (100) nach Anspruch 2, wobei der erste Festkörperschalter (206) und der zweite Festkörperschalter (2308) Metalloxid-Halbleiter-Feldeffekttransistoren sind.

4. Festkörperrelaismodul (100) nach einem der vorhergehenden Ansprüche, wobei die untere Abdeckung (228) aus einem Material mit einer Wärmeleitfähigkeit von mindestens 50 Watt/Meter-°K gebildet ist.

5. Festkörperrelaismodul (100) nach Anspruch 1, wobei die obere Abdeckung (202) eine Vielzahl von Kerben (304) in der oberen Abdeckung (202) definiert, die bemessen, geformt und angeordnet sind, um eine Vielzahl von Sammelschienen aufzunehmen, die an dem ersten Hochspannungseingangsanschluss (210) und dem ersten Hochspannungsausgangsanschluss (214) befestigt sind.

6. Festkörperrelaismodul (100) nach Anspruch 5, wobei der erste Hochspannungseingangsanschluss (210) und der erste Hochspannungsausgangsanschluss (214) eine ebene Schnittstellenoberfläche aufweisen, die konfiguriert ist, um eine der Vielzahl von Sammelschienen zu kontaktieren.

7. Festkörperrelaismodul (100) nach Anspruch 6, wobei ein Gewindeloch in jeder der ebenen Schnittstellenoberflächen definiert ist, das konfiguriert ist, um ein Gewindebefestigungselement aufzunehmen, das sich durch ein Loch in jeder der Vielzahl von Sammelschienen erstreckt, wodurch die Vielzahl von Sammelschienen an dem ersten Hochspannungseingangsanschluss (210) und dem ersten Hochspannungsausgangsanschluss (214) befestigt wird.

8. Festkörperrelaismodul (100) nach einem der vorhergehenden Ansprüche, wobei die elektronische Steuerung (220) auf einer Steuerleiterplatte (218) getrennt von der Leistungsleiterplatte (204) und in elektrischer Kommunikation mit der Leistungsleiterplatte (204) angeordnet ist.

9. Festkörperrelaismodul (100) nach einem der vorhergehenden Ansprüche, wobei die Steuerleiterplatte (218) eine Vielzahl von Niederspannungsanschlüssen (226) beinhaltet, die sich von der Steuerleiterplatte (218) erstrecken, und wobei die obere Abdeckung (202) eine Öffnung definiert, durch die auf die Vielzahl von Niederspannungsanschlüssen zugegriffen werden kann.

10. Festkörperrelaismodul (100) nach Anspruch 9, wobei die Vielzahl von Niederspannungsanschlüssen an der oberen Abdeckung (202) über die Steuerleiterplatte (218) befestigt ist.

11. Festkörperrelaismodul (100) nach einem der vorhergehenden Ansprüche, ferner umfassend eine Treiberschaltung (908), die mit dem ersten Festkörperschalter (206) und der elektronischen Steuerung (220) verbunden ist, wobei die Treiberschaltung (908) konfiguriert ist, um den ersten Festkörperschalter (206) aufgrund von Befehlen von der elektronischen Steuerung (220) in den leitenden Zustand oder in den nichtleitenden Zustand zu versetzen.

12. Festkörperrelaismodul (100) nach Anspruch 11, ferner umfassend:
eine Nebenschlussüberstromerfassungsschaltung in Kommunikation mit der elektronischen Steuerung (220); und
eine Entsättigungsüberstromerfassungsschaltung in Kommunikation mit der elektronischen Steuerung (220), wobei die elektronische Steuerung (220) konfiguriert ist, um die Treiberschaltung (908) anzuweisen, den ersten Festkörperschalter (206) in den nichtleitenden Zustand zu versetzen, wenn die Nebenschlussüberstromerfassungsschaltung oder die Entsättigungsüberstromerfassungsschaltung einen Überstromzustand erfasst.

13. Festkörperrelaismodul (100) nach Anspruch 12, wobei die elektronische Steuerung (220) konfiguriert ist, um die Treiberschaltung (908) anzuweisen, den ersten Festkörperschalter (206) weniger als 200 Nanosekunden in den leitenden Zustand zu versetzen, nachdem die Nebenschlussüberstromerfassungsschaltung oder die Entsättigungsüberstromerfassungsschaltung einen Überstromzustand erfasst.

## Revendications

1. Un module relais statique (100), comprenant :
un premier commutateur statique (206) configuré pour établir et interrompre une connexion électrique entre une première borne d'entrée haute tension et une première borne de sortie haute tension (214, 216) disposées sur une carte de circuit d'alimentation (204) ;
un contrôleur électronique (220) en communication avec le premier commutateur statique (206) et configuré pour mettre le premier commutateur statique (206) dans un état conducteur ou dans un état non conducteur ;
un capot supérieur (202) formé d'un matériau thermoplastique électriquement isolant, la carte de circuit d'alimentation (204) étant disposée à l'intérieur d'une cavité définie par le capot supérieur (202), et le capot supérieur (202) définissant une pluralité d'ouvertures (302) au travers desquelles s'étendent la première borne d'entrée haute tension (210) et la première borne de sortie haute tension (214) ;
un capot inférieur (228) formé d'un matériau thermiquement conducteur en communication thermique avec le premier commutateur statique (206) ;
une pâte d'interface thermique (604) disposée entre une surface interne (606) du capot inférieur (228) et des surfaces du premier commutateur statique (206) ; et
une plaque d'interface thermique (608) fixée à une surface externe (610) du capot inférieur (228) par une première couche adhésive (614) sur une surface interne (606) de la plaque d'interface thermique (608),
dans lequel la plaque d'interface thermique (608) comprend une couche d'un film amovible (618) fixée à une seconde couche adhésive (616) sur une surface externe (610) de la plaque d'interface thermique (608).

2. Le module relais statique (100) selon la revendication 1, comprenant en outre :
un second commutateur statique (208) configuré pour établir et interrompre une connexion électrique entre une seconde borne d'entrée haute tension (212) et une seconde borne de sortie haute tension (216) disposées sur la carte de circuit d'alimentation (204).

3. Le module relais statique (100) selon la revendication 2, dans lequel le premier commutateur statique (206) et le second commutateur statique (208) sont des transistors à effet de champ métal-oxyde-semiconducteur.

4. Le module relais statique (100) selon l'une des revendications précédentes, dans lequel le capot inférieur (228) est formé d'un matériau ayant une conductivité thermique d'au moins 50 watts/mètre-°K.

5. Le module relais statique (100) selon la revendication 1, dans lequel le capot supérieur (202) définit une pluralité d'encoches (304) du capot supérieur (202) qui sont dimensionnées, conformées, et agencées pour loger une pluralité de barres bus fixées à la première borne d'entrée haute tension (210) et à la première borne de sortie haute tension (214).

6. Le module relais statique (100) selon la revendication 5, dans lequel la première borne d'entrée haute tension (210) et la première borne de sortie haute tension (214) ont une surface d'interface plane configurée pour venir en contact avec l'une de la pluralité de barres bus.

7. Le module relais statique (100) selon la revendication 6, dans lequel est défini dans chacune des surfaces d'interface planes un orifice taraudé qui est configuré pour recevoir une fixation filetée s'étendant au travers d'un orifice dans chacune de la pluralité de barres bus, en fixant ainsi la pluralité de barres bus à la première borne d'entrée haute tension (210) et à la première borne de sortie haute tension (214).

8. Le module relais statique (100) selon l'une des revendications précédentes, dans lequel le contrôleur électronique (220) est disposé sur une carte de circuit de contrôle (218) distincte de la carte de circuit d'alimentation (204) et en communication électrique avec la carte de circuit d'alimentation (204).

9. Le module relais statique (100) selon l'une des revendications précédentes, dans lequel la carte de circuit de contrôle (218) comprend une pluralité de bornes basse tension (226) s'étendant depuis la carte de circuit de contrôle (218), et dans lequel le capot supérieur (202) définit une ouverture au travers de laquelle il est possible d'accéder à la pluralité de bornes basse tension.

10. Le module relais statique (100) selon la revendication 9, dans lequel la pluralité de bornes basse tension sont fixées au capot supérieur (202) via la carte de circuit de contrôle (218).

11. Le module relais statique (100) selon l'une des revendications précédentes, comprenant en outre un circuit de pilotage (908) connecté au premier commutateur statique (206) et au contrôleur électronique (220), le circuit de pilotage (908) étant configuré pour mettre le premier commutateur statique (206) à l'état conducteur ou à l'état non conducteur à raison de commandes provenant du contrôleur électronique (220).

12. Le module relais statique (100) selon la revendication 11, comprenant en outre :
un circuit de détection de surintensité à shunt en communication avec le contrôleur électronique (220) ; et
un circuit de détection de surintensité à désaturation en communication avec le contrôleur électronique (220), le contrôleur électronique (220) étant configuré pour commander le circuit de pilotage (908) afin de mettre le premier commutateur statique (206) à l'état non conducteur lorsque le circuit de détection de surintensité à shunt ou le circuit de détection de surintensité à désaturation détecte une condition de surintensité.

13. Le module relais statique (100) selon la revendication 12, dans lequel le contrôleur électronique (220) est configuré pour commander le circuit de pilotage (908) pour mettre le premier commutateur statique (206) à l'état conducteur moins de 200 nanosecondes après que le circuit de détection de surintensité à shunt ou le circuit de détection de surintensité à désaturation ont détecté une condition de surintensité.
